# EUROPEAN PATENT APPLICATION

(11) **EP 0 582 076 A1**
(43) Date of publication of application: **09.02.1994**
(21) Application number: 93110134.9
(22) Date of filing: 24.06.1993
(51) Int. Cl.: H01L 27/082

(54) **Emitter coupled logic semiconductor device**

(30) Priority: 29.06.1992 KR 1145692
(71) Applicant: ELECTRONICS AND TELECOMMUNICATIONS RESEARCH INSTITUTE, Daejeon-shi (KR)
(72) Inventor: Shin, Hee-Cheon, Daeduk-gu, Daejeon-shi (KR); Song, Won-Chul, Yusong-gu, Daejeon-shi (KR); Lee, Kyu-Hong, Daeduck-ku, Daejeon-shi (KR); Lee, Jin-Hyo, Chung-ku, Daejeon-shi (KR)
(74) Representative: Kador & Partner

(57) **Abstract**

A current mode logic and emitter coupled logic circit having a structure in that suitable for use to embody a current mode logic circuit or emitter coupled logic circuit comprises an upwardly operating transistor serving as a CML switching transistor on a P-type semiconductor wafer having an upper N-type region, an intermediate P-type region and lower N-type region, the upper N-type region functioning as a collector of the transistor, the P-type region functioning as a base thereof and the lower N-type region serving as an emitter thereof ; and, a downwardly operating transistor serving as a constant current transistor for a CML having a collector formed from the lower N-type region, a base formed from the P-type region and an emitter from the upper N-type region, the upper N-type area and the P-type region of the transistors being electrically isolated by trenches and etc and the N-type regions of the transistors of the CML circuit is the same region formed on the P-type wafer.

According to the present invention since the emitter of the switching transistor and the collector of the constant current source transistor in the CML circuit are naturally connected to each other by way of the N-type silicon region formed on the P-type wafer substrate without using separative contacts, a degree of integration can be greatly improved as compared with the conventional structure. In addition, since the capacitor is minimized between the silicon substrate and the collectors of the switching transistors, an operation speed of the circuit can be increased considerably.

## Description

### BACKGROUND OF THE INVENTION

### 1. Field of the Invention

The present invention relates to a logic element structure suitable for use to embody a current mode logic circuit or emitter coupled logic circuit, more particularly, to a logic semiconductor device in which a switching transistor and a constant current source transistor are integrated in a single N-channel silicon region electrically isolated by way of an insulating film or the like.

### 2. Description of the prior Art

In general, such a current mode logic (CML) circuit is known a non-saturation logic circuit which achieves a given logic function by changing current with use of a pair of switching transistors each having an emitter connected to each other.

With such a CML circuit, because the transistor are not saturated, the circuit is operated at high speed but has a relatively higher power consumption.

Substantially, with a structure of a logic element constituting an emitter coupled logic (ECL) circuit, the structure of the logic element for the aforementioned CML circuit is specially provided with emitter follower using a bipolar transistor which is formed in a separative N-channel region.

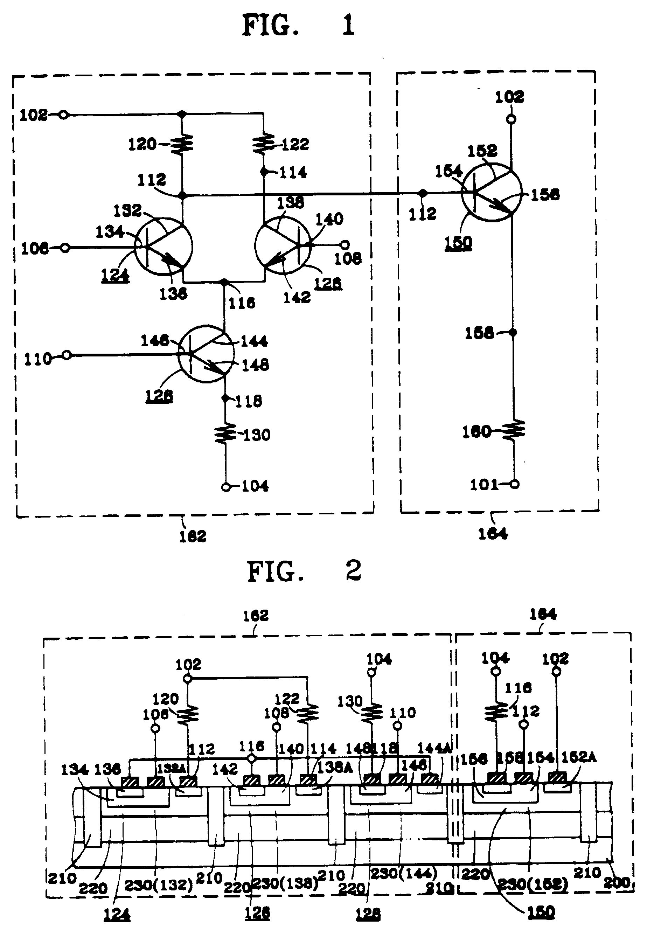

Fig. 1 shows an inverter circuit of an example of such a CML and ECL circuit and illustrates an equivalent circuit of the structures shown in Figs. 2 to 4. Therefore, like components are denoted by the same reference numeral in Figs. 1 to 4.

In Fig. 1, reference numeral 162 denotes such a CML circuit. An emitter follower circuit 164 is connected to the CML circuit 162 to form such an ECL circuit.

The operation of the CML inverter circuit in Fig. 1 will be made as follows. As an input end 106 is biased by a voltage lower than that of a first constant voltage node 108, a current flows toward a second power supply node 104 through a resistor 122, a transistor 126 and a constant current source transistor 128 and a resistor 130 while a current flowing through a resistor 120 and a transistor 124 is inhibited. Accordingly, the voltage appeared on the output node of the CML inverter is equal to the high level voltage of the first power supply node 102 and the output node 158 of the ECL inverter is thus to be a high level, that is, a voltage level defined by subtracting a voltage dropped between a base and an emitter of a transistor 150 from a voltage on the output node 112 of the CML inverter.

On the contrary, when the input end 106 is supplied with a voltage higher than that of the first constant voltage node 108, a current flowing through the resistor 122 and the transistor 126 is cutted off and, hence, the current supplied to the input end 102 flows towards to a second power supply node 104 through a resistor 120, a transistor 124, a constant current power transistor 128, and a resistor 130. Therefore, the output node 112 of the CML inverter is set to a low level voltage defined by subtracting a drop in voltage across the resistor 120 from the first power supply node 102, while the voltage of the output node 158 of the ECL inverter is also set to a low level defined by subtracting a base-emitter voltage of the transistor 150 from the CML inverter output node 112.

Fig. 2 shows a cross-section view of a conventional transistor embodying the CML and ECL circuits shown in Fig. 1 and a circuit diagram of the transistor.

Referring to Fig. 2, reference numerals 162 denotes a cross-section view and circuit diagram of a transistor structure of a CML circuit and 164 denotes a cross-section view end circuit diagram of a transistor structure forming an emitter follower stage.

The transistors which form a CML and ECL circuit respectively are electrically insulated and have contacts of emitter, base and collector being positioned at an upper side of a wafer. The contacts may be connected to form a circuit.

In the drawing, resistors, generally designated 120, 122, 130 and 150 denotes an equivalent circuit. A highly impurity depend N-type buried layer 220 is defined between a P-type silicon substrate 200 and a N-type epitaxial layer 230. An insulating material 210 is filled up in trenches which are formed between the transistors 124, 126, 128 and 150 so as to electrically isolate the transistors 124, 126, 128 and 150.

P-type regions, generally designated 134, 140, 146 and 154 in N-type epitaxial layers 230 serve as bases of the transistors, respectively and highly impurity doped N-regions 136, 142, 148 and 156 which are presented in the P-type regions 134, 140, 146 and 154 respectively serve as emitters of the transistors 124, 126, 128 and 150, respectively. The epitaxial layers 230 serve as collectors 132, 138, 144 and 152 of the transistors 124, 126, 128 and 150, respectively.

Moreover, highly impurity doped N-type layers 132A, 138A, 144A and 152A which are disposed in the epitaxial layers 230 serve to provide ohmic-contact between the contacts 112, 114, 116 and 120 and the collectors 132, 138, 144 and 152 of the respective transistors 124, 126, 128 and 150.

With the CML and ECL circuit having the structure of such a conventional semiconductor device, the N-, P- and N-type regions corresponding the emitter, the bases and the collectors of the respective transistors are electrically isolated among the transistors on the P-type wafer 200 and the contacts of the emitters, the bases and the collectors of the transistors through which a circuit is connected are arranged on the upper surface of the semiconductor wafer. Therefore, the transistor structure has a lowed degree of integration.

Further, if a connection capacitor is defined between the collectors 132, 138, 144 and 152 of the transistors and the P-type semiconductor wafer substrate 200, the same is connected to the collectors 112 and 114 of the switching transistors in Fig. 1. Accordingly, an input signal is passed through a logic gate with an increased time under a power given to the CML and ECL circuits, decreasing in operational speed and increasing in power consumption unexpectedly.

### SUMMARY OF THE INVENTION

Accordingly, an object of the present invention is to provide a CML and ECL semiconductor device in which the number of contacts is greatly reduced, improving a degree of integration than that of a conventional semiconductor device.

Another object of the present invention is to provide a CML and ECL semiconductor device which has a high operation characteristic.

In order to the aforementioned objects, according to an aspect of the present invention, there is provided to a CML and ECL semiconductor device comprising an upwardly operating transistor serving as a CML switching transistor on a P-type semiconductor wafer having an upper N-type region, an intermediate P-type region and lower N-type region, the upper N-type region functioning as a collector of the transistor, the P-type region functioning as a base thereof and the lower N-type region serving as an emitter thereof ; and, a downwardly operating transistor serving as a constant current transistor for a CML having a collector formed from the lower N-type region, a base formed from the P-type region and an emitter from the upper N-type region, the upper N-type area and the P-type region of the transistors being electrically isolated by trenches and etc and the N-type regions of the transistors of the CML circuit is the same region formed on the P-type wafer.

According to another aspect of the present invention, a CML and ECL semiconductor device, a junction capacitor on N-type and P-type wafer substrate is connected to a common emitter in a CML circuit and a variation in voltage of the emitter is greatly reduced than that of the respective collectors of the transistors. As a result, the operation speed of the transistor is highly improved.

The above and other objects, features and advantages of the invention will be apparent from the following description taken with reference to the accompanying drawings.

### BRIEF DESCRIPTION OF THE DRAWINGS

Fig. 1 is a view showing an example of a current mode logic (CML) and emitter coupled logic circuit ;
Fig. 2 is a view showing a conventional element structure embodying a current mode logic and emitter coupled logic circuit made by connecting a single element ;
Fig. 3 is a view showing a current mode logic and emitter coupled logic element according to a first embodiment of the present invention ; and,
Fig. 4 is a view showing of a current mode logic and emitter coupled logic element according to a second embodiment of the present invention.

### DETAILED DESCRIPTION OF THE INVENTION

Thereinafter, preferred embodiments of the present invention will be described in detail.

Referring to Fig. 3 showing a first embodiment of the present invention, which embodies a current mode logic (CML) and emitter coupled logic (ECL) circuit, and plurality of transistors which form the CML and ECL circuit are integrated in a single epitaxial region 230 which is electrically isolated by means of trench filled with an insulative material 210 so as to provide an improved integration of the circuit, and a silicon substrate 200 is isolated from collectors 132 and 138 of transistors 124 and 126 to minimize a capacitor between the substrate 200 and the collectors 132 and 138 of the transistors 124 and 126.

A portion, generally designated 162 denotes a cross-section of a logic element forming the CML circuit and a circuit arrangement thereof and portion, generally designated 164, denotes a cross-section of transistors forming an emitter follower stage and a circuit arrangement thereof.

In the drawing, resistors 120, 122, 130 and 160 are denoted by equivalent circuits. A highly impurity doped N-type buried layer 220 is defined between the P-type silicon substrate 200 and a N-type epitaxial layer 230. The insulative files or insulators 210 serves to electrically isolate the transistors 124 and 126 of the CML element and the transistors 150 of the emitter follower stage 164.

According to the present embodiment, the CML element is formed with enhancement type transistors 124 and 126 and the emitter follower stage 164 is formed with a depletion type transistor 150.

P-type regions, generally designated 134, 140, 146 and 154, which are defined in the N-type epitaxial layers 230 serve as bases of the transistors and the highly impurity doped N-type regions 132 and 138 which are presented in the P-type regions 134 and 140 serve as collectors of the transistors 124 and 126, respectively. The highly impurity doped N-type regions 148 and 156 in the P-type regions 146 and 154 serve as emitters of the transistors 128 and 150, respectively.

Furthermore, the epitaxial layers 230 serve as emitters 136 and 142 of the transistors 124 and 126, respectively and also, serve as collectors 144 and 152 of the transistors 128 and 150 and a contact 116.

Now, description will be made with reference to a method of manufacturing the structure of the logic circuit shown in Fig. 3. The P-type wafer substrate 200 is firstly diffused with an N-type impurity such as arsenic. As to form a highly impurity-doped buried layer and grow lowly impurity doped N-type epitaxial layers 230.

Then, trenches 210 are formed by means of a dry etching tool and then filled up with insulative films so as to isolate the respective elements.

After an oxide film having a predetermined width is grown in an entire surface of the wafer substrate, boron (B) impurity is injected into base regions 134, 140, 146 and 154 by using a mask. Arsenic (As) impurity is injected into the emitter regions 148 and 156 of a constant current source transistor and emitter follower stage and the collector regions 132 and 138 of switching transistors as well as collectors contact region 152A of the transistors of the emitter follower stage, by using a mask.

Consequently, the resistors 120, 122, 130 and 160 of poly silicon are formed on the oxide film of the surface of the wafer substrate and metallic wiring is connected to desired contacts by using a mask.

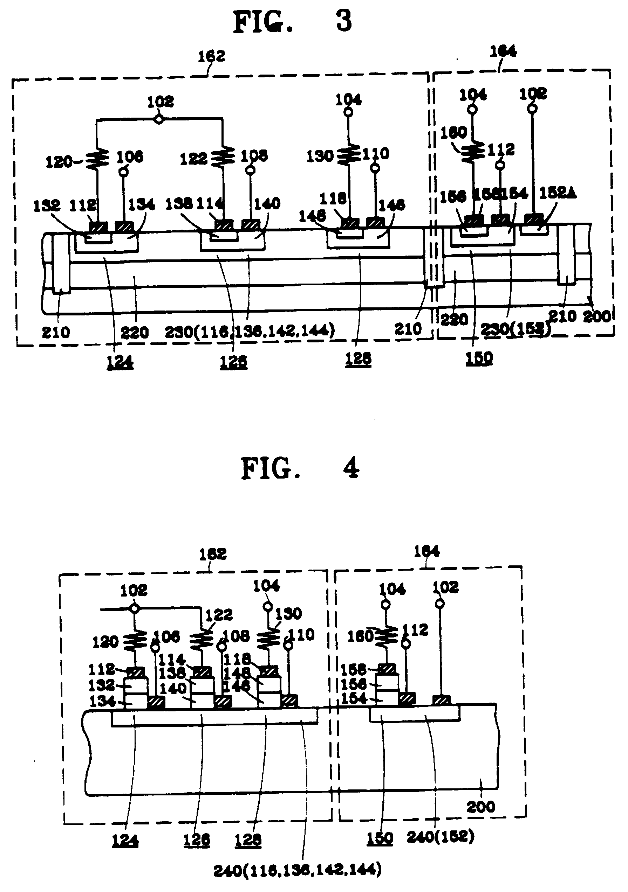

Referring to Fig. 4 showing a second embodiment of the present invention, which embodies a CML and ECL circuit, a bipolar transistor having a vertical structure is illustrated.

More particularly, a plurality of transistors needed for a CML circuit arrangement are integrated in a single N-type area 240 which is electrically isolated from the P-type wafer substrate 200 to improve integration of the element. Further, isolation is effected between the silicon substrate 200 and the collectors 132 and 138 of the transistors 124 and 126 which serve as switching elements. Accordingly, a capacitor between the substrate and collector can be minimized considerably.

A portion, generally designated 162, denotes a cross-section of logic elements 124, 126 and 128 forming a CML circuit and a circuit connection thereof and a portion, generally designated 164, denotes a cross-section of an emitter follower stage transistor 150. The portions 162 and 164 form a cross-section of a logic element of an ECL circuit and a circuit connection arrangement thereof.

In the drawing, resistors 120, 122, 130 and 160 are illustrated by equivalent circuit. A highly impurity doped N-type diffusion region 240 is formed in the P-type silicon substrate 200 so as to electrically isolate CML element 124, 126 and 128 and an emitter follower stage transistor 150. Trenches are defined between the transistor and the elements to isolate N-type epitaxial layers 132, 138, 148 and 156 from P-type regions 134, 140, 146 and 154 formed over the upper surface of the wafer substrate 200. N-type diffusion layer 240 in the wafter substrate 200 is extended to connect the transistors of the CML element.

In the CML element, the switching elements are consisted of enhancement type transistors 124 and 126 and the constant current source transistor is consisted of a depletion type transistor 128. The emitter follower stage is employed with a depletion type transistor 150.

Furthermore, the highly impurity doped N-type diffustion regions 240 serve as emitter 136 and 142 of the transistor 124 and 126 while the region 240 serve as emitter 144 and 152 in a case of the transistors 128 and 150.

Meanwhile, highly impurity doped N-type regions 132 and 138 on the P-region serve as collectors of the switching transistors 124 and 126 while the N-type regions 148 and 156 serve as emitters of the constant current source transistor and the emitter follower stage transistor 128 and 150.

In accordance with a method of manufacturing a structure of the logic circuit shown in Fig. 4, a predetermined amount of impurity, for example, boron (B) is injected to an entire surface of the P-type wafer substrate 200 to form bases 134, 140, 146 and 154 of the transistors on the upper side of the wafer substrate 200. Consequently, portions excluding a pillar for forming the transistor are removed by way of a dry etching process using a mask and a region for forming the N-type region 240 is then defined by using a mask. An impurity, for example, arsenic (As) is injected and diffused into the region for the N-type region 240.

Next, poly silicon layer is extended on a side of bases of the transistors. An boron impurity, for example, is highly doped and spaces defined between the pillars are filled up with insulative films to form the n-type regions 132, 138, 148 and 156 on the upper side of the transistors. Next, poly silicon is deposited on the insulative films to form the resistors 120, 122, 130 and 160 and metallic wirings are connected to contacts of the respective elements by using a mask to thereby complete the circuit shown in Fig. 4.

As noted above, according to the present invention since the emitter of the switching transistor and the collector of the constant current source transistor in the CML circuit are naturally connected to each other by way of the N-type silicon region formed on the P-type wafer substrate without using separative contacts, a degree of integration can be greatly improved as compared with the conventional structure. An addition, since the capacitor is minimized between the silicon substrate and the collectors of the switching transistors, an operation speed of the circuit can be increased considerably.

Although the present invention has been described with reference to the specified embodiment, it can be understood that may changes and modifications will be made therein without departing for the spirit and scope of the invention.

## Claims

1. An emitter coupled logic semiconductor device having at least a pair of switching transistors for switching the flow of current supplied through a first power supply node, a constant current source transistor for providing the current supplied through one of said switching transistors to a second power supply node and an emitter follower transistor for output buffer, comprising :
N-type epitaxial layers on a P-type for forming emitters of said switching transistors and a collector of said constant current source transistor ;
at least three P-type regions in said N-type epitaxial layers for forming bases of said switching transistors and constant current source transistor ; and,
at least three N-type regions in said P-type regions for forming collectors of said switching transistors and an emitter of said constant current source transistor.

2. An emitter coupled logic semiconductor device according to claim 1, wherein said switching transistors and said constant current source transistor are integrated in the N-type epitaxial layer electrically isolated on said P-type substrate.

3. An emitter coupled logic semiconductor device according to claim 1 or 2, further comprising a highly impurity doped N-type buried layer formed between said N-type epitaxial layers and said P-type substrate.

4. An emitter coupled logic semiconductor device having at least a pair of switching transistors, a constant current source transistor and an emitter follower transistor, comprising :
highly impurity doped first N-type regions formed in said P-type wafer for forming emitters of said switching transistors and a collector of said constant current source transistor ;
highly impurity doped second N-type regions formed in said P-type wafer substrate for forming a collector of said emitter follower transistor ;
at least three P-type regions in said N-type regions for forming bases of said switching transistors and said constant current source transistor, said P-type regions having a pillar shape, respectively ;
a separative P-type area in said second N-type region for forming a base of said emitter follower transistor, said P-type area having a pillar shape ; and,
at least four N-type regions on the upper side of said P-type regions for forming collectors of said switching transistors and emitters of said constant current source transistor and said emitter follower transistor, each of said N-type regions having a pillar shape.

5. An emitter coupled logic semiconductor device according to claim 4, wherein said switching transistors and said constant current transistor are integrated in said first N-type regions electrically isolated from said P-type substrate without being electrically isolated from each other.
